# EUROPEAN PATENT APPLICATION

(11) **EP 3 456 857 A1**
(43) Date of publication of application: **20.03.2019**
(21) Application number: 17872876.2
(22) Date of filing: 29.12.2017
(51) Int. Cl.: C23C 14/34, C23C 4/06, C23C 4/123, C23C 4/134, C23C 28/02, B22F 9/08

(54) **METHOD FOR PREPARING TARGET MATERIAL AND TARGET MATERIAL**

(30) Priority: 04.08.2017 CN 201710661544
(71) Applicant: Miasolé Equipment Integration (Fujian) Co., Ltd., 362000 Quanzhou Fujian (CN)
(72) Inventor: ZENG, Yulin, Quanzhou, Fujian 362000 (CN); WAN, Jie, Quanzhou, Fujian 362000 (CN); XU, Xiaohua, Quanzhou, Fujian 362000 (CN)
(74) Representative: D'Halleweyn, Nele Veerle Trees Gertrudis
(86) International application number: PCT/CN2017/120074
(87) International publication number: WO 2019/024421

(57) **Abstract**

The present application relates to a method for preparing a target material, the method including: spraying a transition layer on the surface of a substrate in an atmospheric atmosphere to obtain a substrate containing the transition layer; spraying a target material layer on the surface of the substrate containing the transition layer in an atmospheric atmosphere. The present application also discloses a method for preparing a tubular target material and a target material.

## Description

### Technical Field

The present application relates to, but is not limited to, a field of solar energy application materials, and in particular to, but is not limited to, a method for preparing a target material and a target material.

### Background

Preparation technology of a target material mainly includes a smelting-casting method, a cryogenic aerodynamic spraying method, an atmosphere-protected plasma spraying method, etc. Chinese Patent CN102286724 discloses a technology for manufacturing a CIG (copper indium gallium) target material by using a vacuum smelting-casting method; Chinese Patent CN201310172489.6 provides a method for preparing a CIG target material by low pressure plasma spraying under a vacuum or protective atmosphere; Chinese Patent CN201310221657.6 provides a method for forming a copper indium gallium rotary target material by a layer-by-layer smelting-casting method, i.e., solidifying copper, indium and gallium, layer-by-layer, on a stainless steel cylinder substrate; Chinese Patent CN201510184794.6 provides a method for preparing a CIG target material by cold gas spraying the ball-milled powder.

### Summary

The following is an overview of the subject matter described in detail herein. This summary is not intended to limit the protection scope of the claims.

The inventors of the present application have studied the methods for preparing a target material as disclosed in the above-mentioned Chinese Patents, and have found out the problems existing therein in depth, which are specifically summarized as follows:
The method provided by the Chinese Patent CN201310172489.6 needs to be carried out in a vacuum chamber or under a protective atmosphere, the equipment used is expensive, the process is complicated, and the method requires that the particle size of the sprayed powder is 2200 to 2600 meshes, and this very fine powder is difficult to prepare, resulting in a high production cost. The method provided by Chinese Patent CN201310221657.6 needs to be carried out in a vacuum or a protective gas atmosphere, the process is complex, and the defects of porosity, coarse crystal grains and the like on the target material caused by the smelting-casting process are difficult to overcome; as to the method provided by the Chinese Patent CN201510184794.6, due to the low-melting-point of gallium metal and the high ductility of indium metal, the yield of the ball-milled indium powder is low, a spherical powder cannot be obtained by ball-milling, the ball-milled indium powder is easy to extend and adhere, and the target material spraying operation cannot be carried out through the existing powder feeding system, therefore, the ball-milled indium powder is not suitable for spraying and producing the CIG target material.

In addition, the inventors of the present application have also found that there are problems in the preparation process of the alloy powder which is a raw material for preparing the target material. Taking the preparation process of indium copper gallium alloy powder as an example, the indium copper gallium alloy has a very wide solid-liquid coexisting temperature range, the temperature for completely melting needs to exceed 500 °C, and the temperature for completely solidification is often as low as 160 °C or below. Therefore, the process from liquid solidification to complete solid state is often accompanied by shrinkage of a very large volume, resulting in failure in obtaining a dense target blank when using a conventional smelting-casting method to prepare an indium copper gallium target material since there would not only be a lot of shrinkage porosity and shrinkage cavity but also the problems of uneven distribution of main components, and the like. The above problems can be solved if the target material is prepared by a method of firstly making indium copper gallium alloy powder and then molding by powder metallurgy or hot coating. However, because the melting point of indium is 156 °C, the melting point of gallium is 29 °C, their melting points are very low, but the melting point of copper is 1083 °C, so there is a great difference between these melting points. Copper gallium intermetallic compound and indium-based alloy phase mainly exist in the powder alloy phase. Because of the low melting point of indium, liquid phase exists between the alloy powders prepared by the conventional gas atomization method, so serious agglomeration and adhesion phenomena easily occur during the cooling process or at room temperature, and a large number of small satellite balls are adhered to the particle surface of the alloy powder; as a result, the yield of the alloy powder is too low, the fluidity of the alloy powder is poor, therefore, it is difficult to meet the requirements of the production process to produce a high-performance target material, and the powder feeding system of thermal spraying is often blocked during the subsequent use process due to unsmooth powder feeding. Similarly, the above problems also exist in the preparation of other alloy powders having a very wide solid-liquid coexisting temperature range and including a metal that has a low melting point.

On the basis of in-depth analysis of the above problems, the inventors of the present application have creatively proposed a method for preparing a target material at a low cost that does not need to be carried out in the presence of a vacuum or a protective gas.

Specifically, the present application provides a method for preparing a tubular target material, the method including:
selecting a stainless steel backing tube which has been cleaned and roughened;
spraying a transition layer on a surface of the selected stainless steel backing tube by using a plasma spraying method, an arc spraying method, an ultrasonic flame spraying method or a cold spraying method in an atmospheric atmosphere, to obtain the stainless steel backing tube containing the transition layer;
spraying a target material layer on the surface of the stainless steel backing tube containing the transition layer by using a plasma spraying method in an atmospheric atmosphere.

In the present application, the transition layer may be sprayed by using a plasma spraying method, an arc spraying method, an ultrasonic flame spraying method, or a cold spraying method, commonly used in the art. As compared with the plasma spraying method, the cold spraying method can obtain a higher bonding strength between the transition layer and the target material layer.

In embodiments of the present application, the tubular target material may be selected from any one of copper indium gallium, silver indium gallium, gold indium gallium, copper tin gallium, silver tin gallium, gold tin gallium, copper silver indium gallium, and copper gold indium gallium tubular target materials. In embodiments of the present application, the tubular target material can be a copper indium gallium tubular target material, the transition layer is a copper indium gallium transition layer, and the target material layer is a copper indium gallium target material layer; the copper indium gallium transition layer is formed of copper indium gallium alloy powders, an atomic ratio of copper/(indium + gallium) in the copper indium gallium alloy powders forming the copper indium gallium transition layer may be 0.5 to 0.8, an atomic ratio of indium/(indium + gallium) may be 0.6 to 0.9, and an atomic ratio of gallium/(indium + gallium) may be 0.1 to 0.4; the copper indium gallium target material layer is formed of copper indium gallium alloy powders, and an atomic ratio of copper/(indium + gallium) in the copper indium gallium alloy powders forming the copper indium gallium target material layer may be 0.8 to 1.1, an atomic ratio of indium/(indium + gallium) may be 0.2 to 0.8, and an atomic ratio of gallium/(indium + gallium) may be 0.2 to 0.8.

In embodiments of the present application, a particle size of the copper indium gallium powders forming the copper indium gallium target material layer may be 10 µm to 150 µm, optionally, 30 µm to 100 µm or 10 µm to 50 µm.

In embodiments of the present application, the transition layer may have a thickness of 50 µm to 300 µm and the target material layer may have a thickness of 1 mm to 20 mm.

Optionally, the transition layer may have a thickness of 100 µm to 300 µm, and the target material layer may have a thickness of 3 mm to 12 mm;

In embodiments of the present application, the target material layer may be sprayed in a reciprocating layer-by-layer spraying manner.

In embodiments of the present application, cooling may be carried out during process of spraying the transition layer and the target material layer, for example, by introducing a cryogenic cooling liquid into the backing tube which is hollow, or by enhancing air flow on an outer surface of the backing tube.

Optionally, the cryogenic cooling liquid may be water having a temperature of 15°C to 25°C, and an outlet water temperature may be 30°C to 60°C.

Optionally, compressed air may be blown to the outer surface of the backing tube to enhance cooling capacity.

Optionally, inert gas may be blown to the outer surface of the backing tube to enhance cool capacity, which manner can also reduce the oxidation rate of the sprayed transition layer and target material layer.

In embodiments of the present application, the backing tube may be rotated at a rate of 100 rpm to 500 rpm during process of spraying the transition layer and the target material layer.

In embodiments of the present application, the alloy powders may be sprayed by a powder feeder at a stable powder-feeding rate which may range from 50 g/min to 300 g/min.

Optionally, the powder-feeding rate may be 80 g/min to 200 g/min.

In embodiments of the present application, the transition layer and target material layer may be sprayed by using a plasma spraying method.

Optionally, plasma gas for plasma spraying may be argon gas, a flow rate may be 50 L/min to 140 L/min, a voltage may be 35 V to 55 V, a current may be 350 A to 600 A, and a spraying distance of a spray gun may be 75 mm to 150 mm.

In embodiments of the present application, the alloy powders forming the transition layer and the alloy powders forming the target material layer may be prepared by the following method:
placing a metal elementary substance for preparing the alloy powders into a reactor;
sealing and heating the reactor after it has been vacuumized, and smelting the metal elementary substance into an alloy solution;
guiding the alloy solution into an atomization center of an atomization device, simultaneously introducing a high pressure inert gas flow and an oxygen-containing gas into the atomization device, and atomizing the alloy solution into small liquid droplets under impact of the high pressure inert gas flow;
obtaining alloy powders by forcibly and rapidly cooling the small liquid droplets due to the promotion of the atomized gas flow;
collecting and sieving the alloy powders for standby use;
the oxygen-containing gas may be oxygen, compressed air, or a combination thereof.

In embodiments of the present application, purity of the metal elementary substance may each be 99.99% to 99.9999%.

Optionally, the purity of the metal elementary substance may each be 99.999% to 99.9999%.

In embodiments of the present application, the reactor may be vacuumized to a vacuum degree of 50 Pa to 500 Pa.

In embodiments of the present application, a temperature of the smelting may be from 750 °C to 1050 °C;

In embodiments of the present application, a time of the smelting may be ≧ 30 minutes.

In embodiments of the present application, the high pressure inert gas flow may be a nitrogen flow or an argon flow, a pressure of the high pressure inert gas flow may be 0.5 MPa to 5 MPa, and a flow rate may be 50 m³/h to 500 m³/h.

Optionally, the pressure of the high pressure inert gas flow may be 1 MPa to 3 MPa and the flow rate may be 100 m³/h to 400 m³/h.

In embodiments of the present application, the high pressure inert gas flow and the oxygen may be simultaneously introduced into the atomization device, a flow rate of the oxygen may be from 10 ml/min to 2000 ml/min, optionally from 50 ml/min to 1000 ml/min;

In embodiments of the present application, the high pressure inert gas flow and compressed air may be simultaneously introduced into the atomization device, and the flow rate of the compressed air may be from 0.05 L/min to 20 L/min.

In embodiments of the present application, the high pressure inert gas flow and the oxygen-containing gas can be respectively introduced into the atomization device after the flow rate is controlled through different tube lines.

In embodiments of the present application, preparation of the alloy powders may be carried out in a gas atomization powder-making machine, the reactor may be a vacuum induction smelting furnace of the gas atomization powder-making machine.

In embodiments of the present application, the pressure difference between the smelting chamber and the atomization chamber of the gas atomization powder-making machine may be from 500 Pa to 0.05 MPa, optionally from 1000 Pa to 10,000 Pa.

In embodiments of the present application, the alloy solution may be guided into the atomization device through a guide tube, which may have a diameter of 0.5 mm to 2 mm.

In embodiments of the present application, the introduced high pressure inert gas flow and the oxygen-containing gas may be sprayed out through a high pressure gas ejection tray of the atomization device of the gas atomization powder-making machine.

In embodiments of the present application, a particle size of the sieved alloy powders may be from 10µm to 50 µm or from 30 µm to 100 µm.

In embodiments of the present application, the alloy powders may have an oxygen content of less than 5000 ppm, and optionally, an oxygen content of 100 ppm to 2000 ppm.

In embodiments of the present application, the tubular target material may have an oxygen content of 200 ppm to 5000 ppm, and optionally, an oxygen content of 300 ppm to 3000 ppm, by mass percent.

In particular, the present application also provides a method for preparing a target material, the method including:
spraying a transition layer on a surface of a substrate in an atmospheric atmosphere, to obtain the substrate containing the transition layer; and
spraying a target material layer on the surface of the substrate containing the transition layer in an atmospheric atmosphere.

In the present application, the transition layer may be sprayed by using a plasma spraying method, an arc spraying method, an ultrasonic flame spraying method, or a cold spraying method, commonly used in the art. As compared with the plasma spraying method, the cold spraying method can obtain a higher bonding strength between the transition layer and the target material layer.

In embodiments of the present application, the target material may be selected from any one of copper indium gallium, silver indium gallium, gold indium gallium, copper tin gallium, silver tin gallium, gold tin gallium, copper silver indium gallium, and copper gold indium gallium target materials.

It is to be understood that the method for preparing a target material provided herein includes, but are not limited to, preparing the target material listed above, which are not intended to limit the present application in any form or substance.

In embodiments of the present application, the target material may be a tubular target material.

In embodiments of the present application, the substrate may be a stainless steel backing tube.

In embodiments of the present application, the target material may be a copper indium gallium target material, the transition layer is a copper indium gallium transition layer, and the target material layer is a copper indium gallium target material layer; the copper indium gallium transition layer is formed of copper indium gallium alloy powders, an atomic ratio of copper/(indium + gallium) in the copper indium gallium alloy powder forming the copper indium gallium transition layer may be 0.5 to 0.8, an atomic ratio of indium/(indium + gallium) may be 0.6 to 0.9, and an atomic ratio of gallium/(indium + gallium) may be 0.1 to 0.4; the copper indium gallium target material layer is formed of the copper indium gallium alloy powders, an atomic ratio of copper/(indium + gallium) in the copper indium gallium alloy powders forming the copper indium gallium target material layer may be 0.8 to 1.1, an atomic ratio of indium/(indium + gallium) may be 0.2 to 0.8, and an atomic ratio of gallium/(indium + gallium) may be 0.2 to 0.8.

In embodiments of the present application, a particle size of the copper indium gallium powders forming the copper indium gallium target material layer may be from 10 µm to 150 µm, optionally, from 30 µm to 100 µm or from 10 µm to 50 µm.

In embodiments of the present application, the transition layer may have a thickness of 50 µm to 300 µm and the target material layer may have a thickness of 1 mm to 20 mm.

Optionally, the transition layer may have a thickness of 100 µm to 300 µm, and the target material layer may have a thickness of 3 mm to 12 mm.

In embodiments of the present application, the target material layer may be sprayed in a reciprocating layer-by-layer spraying manner.

In embodiments of the present application, cooling may be carried out during process of spraying the transition layer and the target material layer, for example, by introducing a cryogenic cooling liquid into a hollow substrate, or by enhancing air flow on the outer surface of the substrate.

Optionally, the cryogenic cooling liquid may be water having a temperature of 15°C to 25°C, and an outlet water temperature may be from 30°C to 60°C.

Optionally, compressed air may be blown to the outer surface of the substrate to enhance the cooling capacity of the cold air flow.

Optionally, inert gas may be blown to the outer surface of the substrate to enhance the cooling capacity of the air flow, which manner can also reduce the oxidation rate of the sprayed transition and target material layers.

In embodiments of the present application, the substrate may be rotated at a rate of 100 rpm to 500 rpm during process of spraying the transition layer and the target material layer.

In embodiments of the present application, the alloy powders may be sprayed by a powder feeder at a stable powder-feeding rate which may range from 50 g/min to 300 g/min.

Optionally, the powder-feeding rate may be 80 g/min to 200 g/min;

In embodiments of the present application, the transition layer and target material layer may be sprayed by using the plasma spraying method.

Optionally, plasma gas of the plasma spraying may be argon gas, a flow rate may be 50 L/min to 140 L/min, a voltage may be 35 V to 55 V, a current may be 350 A to 600 A, and a spraying distance of a spray gun may be 75mm to 150mm.

In embodiments of the present application, the alloy powders forming the transition layer and the alloy powders forming the target material layer may be prepared by the following method:
placing a metal elementary substance for preparing the alloy powders into a reactor;
sealing and heating the reactor after it has been vacuumized, and smelting the metal elementary substance into an alloy solution;
guiding the alloy solution into an atomization center of an atomization device, simultaneously introducing a high pressure inert gas flow and an oxygen-containing gas into the atomization device, and atomizing the alloy solution into small liquid droplets under impact of the high pressure inert gas flow;
obtaining alloy powders by forcibly and rapidly cooling the small liquid droplets due to the promotion of the atomized gas flow;
collecting and sieving the alloy powder for standby use.

In embodiments of the present application, purity of the metal elementary substance may each be 99.99% to 99.9999%.

Optionally, the purity of the metal elementary substance may each be 99.999% to 99.9999%.

In embodiments of the present application, the reactor may be vacuumized to a vacuum degree of 50 Pa to 500 Pa.

In embodiments of the present application, a temperature of the smelting may be from 750 °C to 1050 °C;

In embodiments of the present application, a time of the smelting may be ≧ 30 minutes.

In embodiments of the present application, the high pressure inert gas flow may be a nitrogen flow or an argon flow, a pressure of the high pressure inert gas flow may be from 0.5 MPa to 5 MPa, and a flow rate may be from 50 m³/h to 500 m³/H.

Optionally, the pressure of the high pressure inert gas flow may be from 1 MPa to 3 MPa and the flow rate may be from 100 m³/h to 400 m³/h.

In embodiments of the present application, the oxygen-containing gas may be oxygen, compressed air, or a combination of oxygen and compressed air.

In embodiments of the present application, the high pressure inert gas flow and the oxygen may be simultaneously introduced into the atomization device, a flow rate of the oxygen may be from 10 ml/min to 2000 ml/min, optionally from 50 ml/min to 1000 ml/min;

In embodiments of the present application, the high pressure inert gas flow and compressed air may be simultaneously introduced into the atomization device, and the flow rate of the compressed air may be from 0.05 L/min to 20 L/min.

In embodiments of the present application, the high pressure inert gas flow and the oxygen-containing gas can be respectively introduced into the atomization device after the flow rate is controlled through different tube lines.

In embodiments of the present application, preparation of the alloy powders may be carried out in a gas atomization powder-making machine, the reactor may be a vacuum induction smelting furnace of the gas atomization powder-making machine.

In embodiments of the present application, the pressure difference between the smelting chamber and the atomization chamber of the gas atomization powder-making machine may be from 500 Pa to 0.05 MPa, optionally 1000 Pa to 10,000 Pa.

In embodiments of the present application, the alloy solution may be guided into the atomization device through a guide tube which may have a diameter of 0.5 mm to 2 mm.

In embodiments of the present application, the introduced high pressure inert gas flow and the oxygen-containing gas can be sprayed out through a high pressure gas ejection tray of the atomization device of the gas atomization powder-making machine.

In embodiments of the present application, a particle size of the sieved alloy powders may be from 10µm to 50 µm or from 30 µm to 100 µm.

In embodiments of the present application, the alloy powders may have an oxygen content of less than 5000 ppm, and optionally, an oxygen content of 100 ppm to 2000 ppm.

In embodiments of the present application, the method of preparing the target material may further includes cleaning, drying, and roughening (e.g., sandblasting) the substrate before the transition layer is sprayed on the surface of the substrate.

In embodiments of the present application, the target material may have an oxygen content of 200 ppm to 5000 ppm, and optionally, an oxygen content of 300 ppm to 3000 ppm, by mass percent.

In particular, the present application also provides a target material which is prepared by the above method for preparing a target material, and the target material has an oxygen content of 200 ppm to 5000 ppm by mass percent.

In embodiments of the present application, the target material may have an oxygen content of 300 ppm to 3000 ppm by mass percent.

In general, the oxygen content in the target material may affect the performance of a thin film subsequently formed on the target material, and the higher the oxygen content is, the worse the performance of the formed thin film is, so it is desirable in the industry to reduce the oxygen content in the target material. Based on the above-mentioned consensus, the preparation of a target material is generally carried out in the presence of vacuum or inert gas, however, this increases the cost of the preparation of the target material. The method for preparing a target material disclosed in the present application overcomes the prejudice of the prior art, and can directly prepare a target material in an atmospheric atmosphere, to obtain a target material with the oxygen content in an acceptable range, thereby reducing the cost of the preparation of the target material; and a better target material product can be obtained by means of cooling and controlling process parameters to further reduce the oxidation phenomenon in the preparation of a target material.

Further, the present application realizes the surface modification of the alloy powders by introducing the controllable oxygen-containing gas during the gas atomization process for preparing an alloy powders, and generates a very thin and smooth oxide layer on the surface of the alloy powders, the oxide layer has a passivation effect, thereby reducing the generation of satellite balls and avoiding a bonding phenomenon in the process of powder storage and transportation.

Other features and advantages of the present application will be set forth in the following description and, in part, will become more apparent from the description, or may be learned by carrying out the present application. The objects and other advantages of the present application may be realized and attained by the structure particularly pointed out in the specification, claims, and drawings.

### Brief Description of Drawings

The accompanying drawings are used to provide a further understanding of the technical solution of the present application and form a part of the specification, and together with the embodiments of the present application, serve to explain the technical solution of the present application and do not constitute a limitation on the technical solution of the present application.
Fig. 1 is a process flow chart for preparing a copper indium gallium tubular target material according to Example 1 of the present application.
Figs. 2 a and b show the morphology of the copper indium gallium alloy powders for the transition layer prepared in Comparative Example 1 and Example 1 of the present application, respectively.

### Preferred Embodiments of the Present Invention

Examples of the present application will be described in detail below with reference to the accompanying drawings in order to make the objects, technical solutions and advantages of the present application more clearly understood. It should be noted that, if without conflict, the examples and features in the examples of the present application may be combined with each other arbitrarily.

The purity of the elemental indium, the elemental copper and the elemental gallium used in the following Examples is 99.9999 %, and all of the elemental indium, the elemental copper and the elemental gallium are common commercial products meeting the national standards of China.

The parameters measured in the following examples were tested using conventional testing methods in the art, if without specific instructions.

The target material prepared in the following examples is copper indium gallium tubular target material, and a stainless steel backing tube is selected as a substrate.

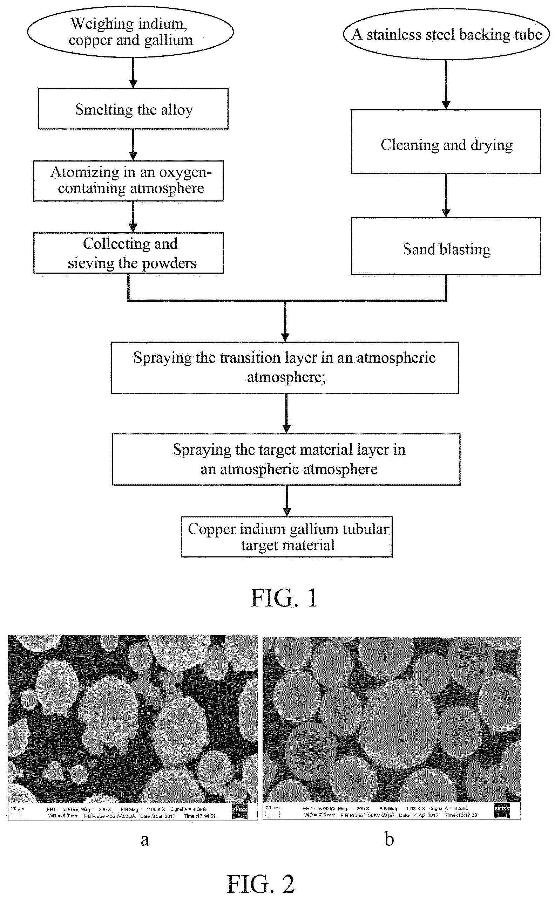

As shown in Fig. 1, a method for preparing a copper indium gallium tubular target material includes the following steps:
weighing elemental indium, elemental copper and elemental gallium, respectively;
smelting the weighed elementary substance indium, the elementary substance copper and the elementary substance gallium into an alloy solution;
atomizing the alloy solution in an oxygen-containing atmosphere to obtain small liquid droplets, and forcibly and rapidly cooling the small liquid droplets to obtain alloy powders; and
collecting and sieving the alloy powders,
wherein the copper indium gallium alloy powders for the transition layer and the copper indium gallium alloy powders for the target material layer are prepared by controlling the content of the three elementary substances and the preparation process parameters, for standby use,
selecting a stainless steel backing tube, cleaning, drying and sand blasting (roughening) the stainless steel backing tube;
spraying the prepared copper indium gallium alloy powders for a transition layer onto the surface of the stainless steel backing tube in an atmospheric atmosphere to form a transition layer;
spraying the prepared copper indium gallium alloy powders for a target material layer onto the surface of the stainless steel backing tube containing the transition layer in an atmospheric atmosphere to form a target material layer, to obtain a copper indium gallium tubular target material.

### Example 1

### (1) Preparation of copper indium gallium alloy powders for a transition layer

1) 50 kg of elemental indium, 30 kg of elemental copper and 20 kg of elemental gallium are weighed respectively, namely the atomic ratio of copper/(indium + gallium) is 0.65, the atomic ratio of indium/(indium + gallium) is 0.60, and the atomic ratio of gallium/(indium + gallium) is 0.40, to prepare the alloy powders for the transition layer.
2) Powders are prepared by smelting and atomizing in an air atomization powder-making machine.

The gas atomization powder-making machine includes a main body, a vacuum smelting chamber and an atomization chamber are one-by-one arranged in the main body from top to bottom, and the two chambers are connected through a tundish with a metal liquid guide tube. The vacuum smelting chamber is provided with a melting device and a heating device, the heating device heats the melting device, the melting device has a liquid outlet, the liquid outlet is communicated with the top of the atomization chamber through a guide tube, a gas nozzle is arranged within the atomization chamber, the gas nozzle is connected with a high pressure inert gas pipeline, the gas nozzle sprays a high pressure inert gas towards the outlet of the guide tube, the atomization chamber is provided with an oxygen-containing gas pipeline and a jet device connected with the oxygen-containing gas pipeline, and the oxygen-containing gas pipeline conveys the oxygen-containing gas to the atomization chamber through the air inlet device.

The three elementary substances are placed into a crucible of the melting device, the power supply is started, the melting device is vacuumarized to a vacuum degree of 200 Pa and heated to 850°C, the three elementary substances are heated and melted for 60 minutes, and a uniform alloy solution is obtained through an electromagnetic stirring force of an induction coil; the vacuum pump is turned off, nitrogen is introduced into the smelting chamber and the atomization chamber, to make the atomization chamber achieve the normal pressure, and the pressure of the smelting chamber is higher than that of the atomization chamber by 9000 Pa.
3) The smelted alloy solution is slowly and evenly poured into the tundish, and the alloy solution flows to the atomization chamber through a metal liquid guide tube(2 mm in diameter) under the action of gravity and the pressure difference (9000 pa) between the vacuum smelting chamber and the atomization chamber; meanwhile, nitrogen gas with the pressure of 3 MPa and the flow rate of 200 m³/h is introduced, as an atomization medium, into the atomization chamber through a high pressure inert gas pipeline, and a clean compressed air with the pressure of 0.8 MPa and the flow rate of 3 L/min is introduced into the atomization chamber through an oxygen-containing gas pipeline while introducing the high pressure nitrogen gas; the alloy solution is atomized into small liquid droplets under the impact of high pressure air flow immediately after leaving the bottom of the guide tube; the small liquid droplets are forced to be rapidly cooled due to the promotion of the atomized gas flow, to obtain alloy powders.
4) The powders prepared by the gas atomization powder-making machine are collected, and sieved by an ultrasonic auxiliary vibrating sieve, to obtain indium copper gallium powder with the particle size between 30 µm and 100 µm.

The yield of indium copper gallium alloy powders is 98 % or more, wherein the yield of powder with particle size of 30 µm to 100 µm is 45 %, the fluidity of the powder is better, the detection result of Hall flowmeter is 14 seconds/50 g, and no obvious agglomeration and conglutination phenomenon occurs between the powders; the oxygen content of the alloy powders is 300 ppm.

### (2) Preparation of copper indium gallium alloy powders for target material layer

1) 35 kg of elemental indium, 40 g of elemental copper and 25 kg of elemental gallium are weighed respectively, namely the atomic ratio of copper/(indium + gallium) is 0.95, the atomic ratio of indium/(indium + gallium) is 0.46, and the atomic ratio of gallium/(indium + gallium) is 0.54 to prepare alloy powders for a target material layer.
2) Copper indium gallium alloy powders for the target material layer are prepared by the same method as the method for preparing copper indium gallium alloy powders for the transition layer, the temperature of the smelting is 920°C, the pressure for atomizing medium argon gas is 2 MPa, the flow rate is 180 m³/h, the compressed air flow rate is 2.5 L/min, the other process parameters are completely the same, and the oxygen content of the alloy powders is 270 ppm.

### (3) Preparation of copper indium gallium tubular target material

A transition layer and a target material layer are sprayed on the surface of the stainless steel backing tube, wherein the backing tube is hollow and has a water inlet and a water outlet.
1) The stainless steel backing tube is cleaned, sand blasted (roughened) and dried.
2) The backing tube is rotated at a rate of 300 rpm, and two rows of nitrogen tube lines at the upper part and the lower part of the backing tube are arranged to directly blow to the backing tube so as to cool and protect the sprayed material from oxidation, wherein the nitrogen flow rate is 180 m3/h. The copper indium gallium alloy powders are conveyed at a powder-feeding rate of 80 g/min through a powder feeder in an atmospheric atmosphere, and a copper indium gallium transition layer with a thickness of 200 µm is sprayed on the surface of the backing tube by using a plasma spraying method, wherein the plasma gas is argon gas, the flow rate is 100 L/min, the spraying voltage is 50 V, the current is 450 A, and the spraying distance is 120 mm, to prepare the stainless steel backing tube containing the copper indium gallium transition layer.
3) The copper indium gallium alloy powders are sprayed at a powder-feeding rate of 120 g/min by a powder feeder in an atmospheric atmosphere, and a copper indium gallium target material layer with a thickness of 12 mm is sprayed on the surface of the stainless steel backing tube containing the copper indium gallium transition layer by using a plasma spraying method, wherein the spraying voltage is 40 V, the current is 500 A, the spraying distance is 100 mm, the plasma gas is argon gas, and the flow rate is 80 L/min.

The oxygen content of the prepared copper indium gallium tubular target material is 1600 ppm.

### Example 2

This Example differs from Example 1 only in that:
Softened water having a temperature of 15°C to 25°C is introduced into the backing tube which is hollow, the temperature of the softened water when leaving the backing tube is 30°C to 40°C, and nitrogen is simultaneously blown to the surface of the backing tube for cooling, the flow rate of the nitrogen is 100 m³/h;

The process of plasma spraying the transition layer includes that: argon gas is used as plasma gas, the flow rate is 60 L/min, the voltage is 40 V, the current is 450 A, the powder-feeding rate is 60 g/min, and the thickness of the copper indium gallium transition layer is 250 µm; the parameters of plasma spraying target material layer are 55 V voltage, 600 A current, 150 mm spraying distance, 140 L/min flow rate of plasma gas argon, 200 g/min powder-feeding rate of copper indium gallium alloy powders, and 3 mm thickness of copper indium gallium target material layer.

The oxygen content of the prepared copper indium gallium tubular target material is 1800 ppm.

### Example 3

This Example differs from Example 1 only in that:
Only cooling water is used for cooling, nitrogen is not used for cooling or protecting, specifically, the softened water having a temperature of 15°C to 25°C is introduced into the hollow backing tube, the temperature of the softened water when leaving the backing tube is 35°C to 40°C.

The plasma gas for plasma spraying transition layer is argon gas, the flow rate is 120 L/min, the powder-feeding rate is 100 g/min, and the thickness of the copper indium gallium transition layer is 200 µm;

The voltage for plasma spraying target material layer by the transition layer is 50 V, the current is 550 A, the spraying distance is 130 mm, the powder-feeding rate is 90 g/min, the flow rate of plasma gas argon gas is 100 L/min, and the thickness of the copper indium gallium target material layer is 5 mm.

The oxygen content of the prepared copper indium gallium tubular target material is 2600 ppm.

### Example 4

This Example differs from Example 1 only in that:
Softened water having a temperature of 20°C is introduced into the hollow backing tube, the temperature of the softened water when leaving the backing tube is 35°C, and the softened water is simultaneously cooled with nitrogen, the flow rate of the nitrogen is 100 m³/h.

A transition layer is sprayed on the surface of the backing tube by a cold spraying method, wherein working gas for cold spraying is nitrogen, the flow rate is 200 m³/h, the temperature is 400°C, the powder-feeding rate is 80 g/min, and the thickness of the copper indium gallium transition layer is 300 µm.

The plasma-sprayed target material layer has 500 A current, 120 mm spraying distance, and 130 g/min powder-feeding rate, and the thickness of the copper indium gallium target material layer is 8 mm.

The oxygen content of the prepared copper indium gallium tubular target material is 1400 ppm.

### Comparative Example 1

Preparation of the copper indium gallium alloy powders for the transition layer: the difference in the preparation of the copper indium gallium alloy powders for the transition layer between Comparative Example 1 and Example 1 lies only in that no compressed air is introduced during atomization.

### Performance test

1. The copper indium gallium alloy powders for the transition layer prepared in Example 1 and Comparative Example 1 were observed by using a scanning electron microscope, and the results were shown in Fig. 2.
As can be seen from Fig. 2, a large number of small satellite balls were adhered to the particle surface of the copper indium gallium alloy powders for the transition layer prepared in Comparative Example 1, and there was an adhesion phenomenon between the powder particles; whereas the copper indium gallium alloy powders for the transition layer prepared in Example 1 had spherical particles with a smooth surface and very few small satellite balls on the surface of the particles.
2. The service performances of the copper indium gallium tubular target material in the coating process were tested. The test results were shown in Table 1.

**Table 1**

| | Thickness of target material mm | Relative density | Oxygen content ppm | Discharge condition during the use of the sputtering | Sputtering performance |
|---|---|---|---|---|---|
| Example 1 | 12 | 97% | 1600 | smooth arcing, no abnormal discharge | excellent sputtering performance |
| Example 2 | 3 | 95% | 1800 | smooth arcing, no abnormal discharge | excellent sputtering performance |
| Example 3 | 5 | 96% | 2600 | smooth arcing, no abnormal discharge | excellent sputtering performance |
| Example 4 | 8 | 98% | 1400 | smooth arcing, no abnormal discharge | excellent sputtering performance, capable of tolerating a higher sputtering power |

This disclosure is illustrative of the principles of examples of the present application and is not intended to limit the application in any form or substance, or to limit the application to particular embodiments. It will be apparent to those skilled in the art that variations, changes, modifications, variations, and the like may be made to the elements, methods, and systems of the technical solutions of the examples of the present application without departing from the principles, spirit, and scope of the examples, technical solutions of the present application as defined in the claims. Embodiments of such variations, changes, modifications, and variations are all included within equivalent examples of the present application, which are all included within the scope as defined by the claims of the present application. Although the examples of the present application may be embodied in many different forms, what is described in detail herein are merely some embodiments of the invention. Furthermore, examples of the present application include any possible combination of some or all of the various embodiments described herein, and are also included within the scope as defined by the claims of the present application. All patents, patent applications, and other cited materials mentioned in this application or anywhere in any cited patent, cited patent application, or other cited material are hereby incorporated by reference in their entirety.

The above disclosure is intended to be illustrative and not exhaustive. Many variations and alternatives will be suggested to those skilled in the art. All such alternatives and variations are intended to be included within the scope of the present claims, wherein the term "including" means "including, but not limited to".

A description of alternative embodiments of the present application has been completed herein. Those skilled in the art will recognize other equivalent changes to the embodiments described herein that are also encompassed by the claims appended hereto.

### Industrial applicability

The method for preparing a target material provided in the present application does not need to be carried out under the condition of vacuum or the existence of a protective gas, thereby reducing the production cost of the target material.

## Claims

1. A method for preparing a tubular target material, the method comprising:
selecting a stainless steel backing tube which has been cleaned and roughened;
spraying a transition layer on a surface of the selected stainless steel backing tube by using a plasma spraying method, an arc spraying method, an ultrasonic flame spraying method or a cold spraying method in an atmospheric atmosphere, to obtain the stainless steel backing tube containing the transition layer;
spraying a target material layer on the surface of the stainless steel backing tube containing the transition layer by using a plasma spraying method in an atmospheric atmosphere.

2. The method according to claim 1, wherein the tubular target material is selected from any one of copper indium gallium, silver indium gallium, gold indium gallium, copper tin gallium, silver tin gallium, gold tin gallium, copper silver indium gallium, and copper gold indium gallium tubular target materials.

3. The method according to claim 1, wherein the tubular target material is a copper indium gallium tubular target material, the transition layer is a copper indium gallium transition layer, and the target material layer is a copper indium gallium target material layer; the copper indium gallium transition layer is formed of copper indium gallium alloy powders, an atomic ratio of copper/(indium + gallium) in the copper indium gallium alloy powders forming the copper indium gallium transition layer is 0.5 to 0.8, an atomic ratio of indium/(indium + gallium) is 0.6 to 0.9, and an atomic ratio of gallium/(indium + gallium) is 0.1 to 0.4; the copper indium gallium target material layer is formed of copper indium gallium alloy powders, an atomic ratio of copper/(indium + gallium) in the copper indium gallium alloy powders forming the copper indium gallium target material layer is 0.8 to 1.1, an atomic ratio of indium/(indium + gallium) is 0.2 to 0.8, and an atomic ratio of gallium/(indium + gallium) is 0.2 to 0.8;
optionally, a particle size of the copper indium gallium powders forming the copper indium gallium target material layer is 10 µm to 150 µm, further optionally 30 µm to 100 µm or 10 µm to 50 µm.

4. The method according to any one of claims 1 to 3, wherein the transition layer has a thickness of 50 µm to 300 µm and the target material layer has a thickness of 1 mm to 20 mm;
optionally, the transition layer has a thickness of 100 µm to 300 µm and the target material layer has a thickness of 3 mm to 12 mm;
optionally, the target material layer is sprayed in a reciprocating layer-by-layer spraying manner.

5. The method according to any one of claims 1 to 4, wherein cooling is carried out during process of spraying the transition layer and the target material layer, optionally by introducing a cryogenic cooling liquid into the backing tube which is hollow or by enhancing air flow on an outer surface of the backing tube; optionally, the cryogenic cooling liquid is water having a temperature of 15°C to 25°C, and an outlet water temperature is 30°C to 60°C; optionally, compressed air or inert gas is blown to the outer surface of the backing tube to enhance cooling capacity.

6. The method according to any one of claims 1 to 5, wherein the backing tube is rotated at a rate of 100 rpm to 500 rpm during process of spraying the transition layer and the target material layer;
optionally, the alloy powders are sprayed by a powder feeder with a powder-feeding rate of 50 g/min to 300 g/min, and further optionally 80 g/min to 200 g/min;
optionally, the transition layer and the target material layer are sprayed by a plasma spraying method, wherein plasma gas is argon gas, a flow rate is 50 L/min to 140 L/min, a voltage is 35 V to 55 V, a current is 350 A to 600 A, and a spraying distance of a spraying gun is 75 mm to 150 mm..

7. The method according to any one of claims 1 to 6, wherein the alloy powders forming the transition layer and the alloy powders forming the target material layer are prepared by:
placing a metal elementary substance for preparing the alloy powders into a reactor;
sealing and heating the reactor after it has been vacuumized, and smelting the metal elementary substance into an alloy solution;
guiding the alloy solution into an atomization center of an atomization device, simultaneously introducing a high pressure inert gas flow and an oxygen-containing gas into the atomization device, and atomizing the alloy solution into small liquid droplets under impact of the high pressure inert gas flow;
obtaining the alloy powders by forcibly and rapidly cooling the small liquid droplets due to the promotion of the atomized gas flow;
collecting and sieving the alloy powders for standby use;
optionally, the oxygen-containing gas is oxygen, compressed air, or a combination thereof.

8. The method according to claim 7, wherein purity of the metal elementary substance is 99.99% to 99.9999%;
optionally,
the purity of the metal elementary substance is 99.999% to 99.9999%;
the reactor is vacuumized to a vacuum degree of 50 Pa to 500 Pa;
a temperature of the smelting is from 750°C to 1050°C;
a time of the smelting ≥ 30 minutes.

9. The method according to claim 7 or 8, wherein the high pressure inert gas flow is a nitrogen gas flow or an argon gas flow, a pressure of the high pressure inert gas flow is 0.5 MPa to 5 MPa, and a flow rate is 50 m³/h to 500 m³/h; optionally, the pressure is 1 MPa to 3 MPa and the flow rate is 100 m³/h to 400 m³/h.

10. The method according to any one of claims 7 to 9, wherein the high pressure inert gas flow and the oxygen are simultaneously introduced into the atomization device, a flow rate of the oxygen is 10 ml/min to 2000 ml/min, and further optionally 50 ml/min to 1000 ml/min;
alternatively, the high pressure inert gas flow and compressed air are simultaneously introduced into the atomization device, and the flow rate of the compressed air is from 0.05 L/min to 20 L/min.

11. The method according to any one of claims 7 to 10, wherein the high pressure inert gas flow and the oxygen-containing gas are respectively introduced into the atomization device after the flow rate is controlled through different tube lines.

12. The method according to any one of claims 7 to 11, wherein preparation of the alloy powders is carried out in a gas atomization powder-making machine, the reactor is a vacuum induction smelting furnace of the gas atomization powder-making machine, the pressure difference between the smelting chamber and the atomization chamber of the gas atomization powder-making machine is from 500 Pa to 0.05 MPa, optionally from 1000 Pa to 10,000 Pa;
optionally,
the alloy solution is guided into the atomization device through a guide tube, wherein the diameter of the guide tube is 0.5 mm to 2 mm;
the introduced high pressure inert gas flow and the oxygen-containing gas are sprayed out through a high pressure gas ejection tray of the atomization device of the gas atomization powder-making machine.

13. The method according to any one of claims 7 to 12, wherein a particle size of the sieved alloy powders is from 10 µm to 50 µm or from 30 µm to 100 µm;
optionally, the alloy powders have an oxygen content of less than 5000 ppm, and further optionally, of 100 ppm to 2000 ppm.

14. The method according to any one of claims 1 to 13, wherein the tubular target material has an oxygen content of 200 ppm to 5000 ppm, optionally an oxygen content of 300 ppm to 3000 ppm, by mass percent.

15. A method for preparing a target material, the method comprising:
spraying a transition layer on a surface of a substrate in an atmospheric atmosphere, to obtain the substrate containing the transition layer; and
spraying a target material layer on the surface of the substrate containing the transition layer in an atmospheric atmosphere.

16. The method according to claim 15, wherein the target material is selected from any one of copper indium gallium, silver indium gallium, gold indium gallium, copper tin gallium, silver tin gallium, gold tin gallium, copper silver indium gallium, and copper gold indium gallium target materials.

17. The method of claim 15, wherein the target material is a copper indium gallium target material, the transition layer is a copper indium gallium transition layer, and the target material layer is a copper indium gallium target material layer; the copper indium gallium transition layer is formed of copper indium gallium alloy powders, an atomic ratio of copper/(indium + gallium) in the copper indium gallium alloy powders forming the copper indium gallium transition layer is 0.5 to 0.8, an atomic ratio of indium/(indium + gallium) is 0.6 to 0.9, and an atomic ratio of gallium/(indium + gallium) is 0.1 to 0.4; the copper indium gallium target material layer is formed of the copper indium gallium alloy powders, an atomic ratio of copper/(indium + gallium) in the copper indium gallium alloy powders forming the copper indium gallium target material layer is 0.8 to 1.1, an atomic ratio of indium/(indium + gallium) is 0.2 to 0.8, and an atomic ratio of gallium/(indium + gallium) is 0.2 to 0.8;
optionally, a particle size of the copper indium gallium powders forming the copper indium gallium target material layer is from 10 µm to 150 µm, further optionally from 30 µm to 100 µm or from 10 µm to 50 µm.

18. The method according to any one of claims 15 to 17, wherein the transition layer has a thickness of 50 µm to 300 µm, and the target material layer has a thickness of 1 mm to 20 mm;
optionally, the transition layer has a thickness of 100 µm to 300 µm, and the target material layer has a thickness of 3 mm to 12 mm;
optionally, the target material layer is sprayed in a reciprocating layer-by-layer spraying manner.

19. The method according to any one of claims 15 to 18, wherein cooling is carried out during process of spraying the transition layer and the target material layer, optionally by introducing a cryogenic cooling liquid into a hollow substrate, or by enhancing air flow on an outer surface of the substrate; optionally, the cryogenic cooling liquid is water having a temperature of 15°C to 25°C, and an outlet water temperature is from 30°C to 60°C; optionally, compressed air or inert gas is blown to the outer surface of the substrate to enhance cooling capacity.

20. The method according to any one of claims 15 to 19, wherein the substrate is rotated at a rate of 100 rpm to 500 rpm during process of spraying the transition layer and the target material layer;
optionally, the alloy powders are sprayed by a powder feeder with a powder-feeding rate of 50 g/min to 300 g/min, and further optionally 80 g/min to 200 g/min;
optionally, the transition layer is sprayed by any one of a plasma spraying method, an arc spraying method, an ultrasonic flame spraying method and a cold spraying method, and the target material layer is sprayed by using the plasma spraying method;
optionally, plasma gas for spraying the transition layer and the target material layer by using the plasma spraying method is argon gas, a flow rate is 50 L/ min to 140 L/min, a voltage is 35 V to 55 V, a current is 350 A to 600 A, and a spraying distance of a spray gun is 75 mm to 150 mm.

21. The method according to any one of claims 15 to 20, wherein the alloy powders forming the transition layer and the alloy powders forming the target material layer are prepared by:
placing a metal elementary substance for preparing the alloy powders into a reactor;
sealing and heating the reactor after it has been vacuumized, and smelting the metal elementary substance into an alloy solution;
guiding the alloy solution into an atomization center of an atomization device, simultaneously introducing a high pressure inert gas flow and an oxygen-containing gas into the atomization device, and atomizing the alloy solution into small liquid droplets under impact of the high pressure inert gas flow;
obtaining the alloy powders by forcibly and rapidly cooling the small liquid droplets due to the promotion of the atomized gas flow;
collecting and sieving the alloy powders for standby use.

22. The method according to claim 21, wherein purity of the metal elementary substance is 99.99% to 99.9999%;
optionally,
the purity of the metal elementary substance is 99.999% to 99.9999%;
the reactor is vacuumized to a vacuum degree of 50 Pa to 500 Pa;
a temperature of the smelting is 750°C to 1050°C;
a time of the smelting ≥ 30 minutes.

23. The method according to claim 21 or 22, wherein the high pressure inert gas flow is a nitrogen gas flow or an argon gas flow, a pressure of the high pressure inert gas flow is from 0.5 MPa to 5 MPa, and a flow rate is from 50 m³/h to 500 m³/h; optionally, the pressure is from 1 MPa to 3 MPa and the flow rate is from 100 m³/h to 400 m³/h.

24. The method of any one of claims 21 to 23, wherein the oxygen-containing gas is oxygen, compressed air, or a combination thereof;
optionally, the high pressure inert gas flow and the oxygen are simultaneously introduced into the atomization device, a flow rate of the oxygen is from 10 ml/min to 2000 ml/min, and further optionally from 50 ml/min to 1000 ml/min;
alternatively, the high pressure inert gas flow and compressed air are simultaneously introduced into the atomization device, and the flow rate of the compressed air is 0.05 L/min to 20 L/min.

25. The method according to any one of claims 21 to 24, wherein the high pressure inert gas flow and the oxygen-containing gas are introduced into the atomization device after the flow rate is controlled through different tube lines.

26. The method according to any one of claims 21 to 25, wherein preparation of the alloy powders is carried out in a gas atomization powder-making machine, the reactor is a vacuum induction smelting furnace of the gas atomization powder-making machine, the pressure difference between the smelting chamber and the atomization chamber of the gas atomization powder-making machine is from 500 Pa to 0.05 MPa, optionally from 1000 Pa to 10,000 Pa;
optionally,
the alloy solution is guided into the atomization device through a guide tube which has a diameter of 0.5 mm to 2 mm;
the introduced high pressure inert gas flow and the oxygen-containing gas are sprayed out through a high pressure gas ejection tray of the atomization device of the gas atomization powder-making machine.

27. The method according to any one of claims 21 to 26, wherein a particle size of the sieved alloy powders is from 10 µm to 50 µm or from 30 µm to 100 µm;
optionally, the alloy powders have an oxygen content of less than 5000 ppm, and further optionally, of 100 ppm to 2000 ppm.

28. The method according to any one of claims 15 to 27, wherein the method for preparing a target material further comprises cleaning, drying and roughening the substrate before the transition layer is sprayed on the surface of the substrate;
optionally, the target material is a tubular target material and the substrate is a stainless steel backing tube.

29. The method according to any one of claims 15 to 28, wherein the target material has an oxygen content of 200 ppm to 5000 ppm, optionally 300 ppm to 3000 ppm, by mass percent.

30. A target material prepared by the method according to any one of claims 1 to 29.
